# EUROPÄISCHE PATENTANMELDUNG

(11) **EP 0 831 565 A1**
(43) Veröffentlichungstag der Anmeldung: **25.03.1998**
(21) Anmeldenummer: 97109917.1
(22) Anmeldetag: 18.06.1997
(51) Int. Cl.: H01R 43/02

(54) **Hochschmelzende elektrisch leitende Verbindung und Verfahren zu deren Herstellung**

(30) Priorität: 19.09.1996 DE 19638209
(71) Anmelder: ROBERT BOSCH GMBH, 70442 Stuttgart (DE)
(72) Erfinder: Mayer, Rolf, 71364 Winnenden (DE)

(57) **Zusammenfassung**

Es wird eine elektrisch leitende Verbindung sowie ein Verfahren zu deren Herstellung vorgeschlagen, wobei eine Kontaktstelle (12) mit einem metallischen Kontaktteil (14) kontaktiert wird. Das Kontaktteil (14) ist zumindest im Bereich der Kontaktstelle (12) mit einer diffusionsaktiven Schicht (19) aus einer Palladium-Nickel-Legierung versehen. Die elektrisch leitende Verbindung wird durch Diffusionslöten bei einer Fügetemperatur von 750 bis 950° C je nach Pd/Ni-Legierung erzeugt.

## Beschreibung

### Stand der Technik

Die Erfindung geht aus von einer hochschmelzenden, elektrisch leitenden Verbindung und einem Verfahren zu deren Herstellung nach der Gattung der unabhängigen Ansprüche.

Thermisch hochbelastbare elektrische Kontaktierungen sind beispielsweise zum Kontaktieren von Gassensoren notwendig, die mit heißen Abgasen in Berührung kommen. Derartige Sensoren sind z. B. Lambdasonden, die im Abgasrohr eines Verbrennungsmotors eingesetzt werden und den Sauerstoffgehalt im Abgas detektieren.

Aus der Druckschrift WO 95 18 777 ist es zum Kontaktieren von keramischen Substraten bekannt, auf das keramische Substrat ein Metallteilchen und Glas enthaltende Haftvermittlerschicht aufzubringen, auf die eine Metallschicht aufgesintert wird. Ein Kontaktstück wird mit der Metallschicht mittels Laserschweißen verbunden.

### Vorteile der Erfindung

Die erfindungsgemäße, elektrisch leitende Verbindung und das erfindungsgemäße Verfahren haben den Vorteil, daß eine temperaturstabile relativ großflächige elektrische Kontaktierung erzielt wird, die dadurch eine hohe mechanische Festigkeit aufweist. Die elektrisch leitende Verbindung hält kurzzeitig Temperaturen von mindestens 1200° C und auf Dauer 800° C aus.

Durch die in den Unteransprüchen aufgeführten Maßnahmen und Verbesserungen sind vorteilhafte Weiterbildungen der elektrisch leitenden Verbindung und des Verfahrens zu deren Herstellung möglich. Eine besonders hohe thermische Stabilität und mechanische Festigkeit der elektrisch leitenden Verbindung wird erzielt, wenn die diffusionsaktive Zwischenschicht 20 bis 85 Masseprozeßt Pd, Rest Ni, vorzugsweise 60 Masseprozent Palladium und 40 Masseprozent Nickel enthält. Eine besonders langzeitstabile Kontaktierung wird erzielt, wenn das Diffusiunslötverfahren unter Schutzgas durchgeführt wird.

### Zeichnung

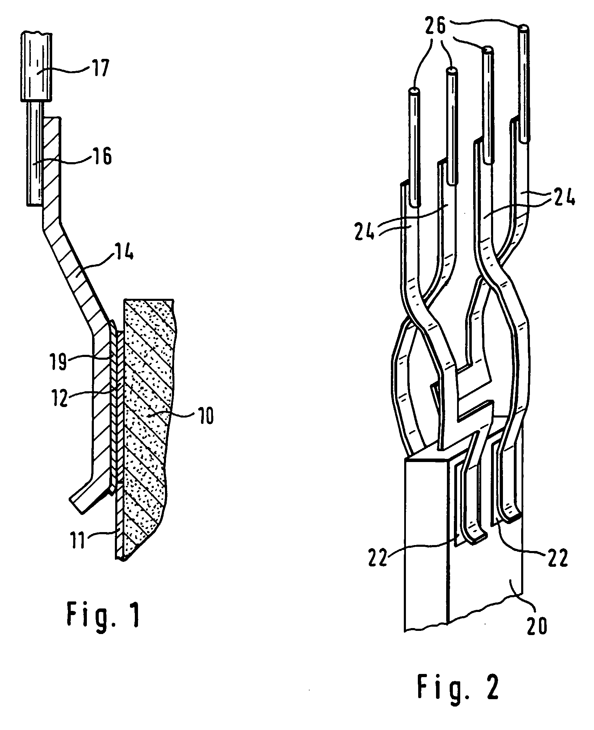

Ein Ausführungsbeisiel der Erfindung ist in der Zeichnung dargestellt und in der nachfolgenden Beschreibung näher erläutert. Es zeigen Figur 1 einen Schnitt durch eine erfindungsgemäße elektrisch leitende Verbindung und Figur 2 eine elektrisch leitende Verbindung gemäß Figur 1 zur Kontaktierung eines planaren Sensorelements.

### Ausführungsbeispiel

Figur 1 zeigt ein Keramiksubstrat 10, auf dem eine elektrische Leiterbahn 11 mit einer Kontaktstelle 12 angeordnet ist. Die Kontaktstelle 12 ist mit einem Kontaktteil 14 kontaktiert, welches mit einem elektrischen Leiter 16 eines Anschlußkabels 17 verbunden ist.

Die Kontaktstelle besteht aus einem Platin-Cermet mit beispielsweise einem Platin-Anteil von 98 %. Das Cermet ist mit dem Substrat versintert, wobei beim Sintern der Keramikbestandteil des Platin-Cermets mit dem Material des Substrats eine feste Verbindung eingeht.

Das Kontaktteil 14 besteht aus einer Nickel- oder Nickel-Legierung und weist im Bereich der Kontaktstelle 12 eine Schicht 19 auf. Die Schicht 12 besteht aus einer Palladium-Nickel-Legierung, mit beispielsweise 60 Masseprozent Palladium und 40 Masseprozent Nickel und einem Schmelzpunkt von 1237° C. Die Schicht 19 kann durch galvanisches Abscheiden oder durch Walzplattieren aufgetragen werden. Es ist auch denkbar, die Schicht 19 durch Sputtern oder Plasmaspritzen aufzubringen. Je nach Herstellungsverfahren der Schicht 19 beträgt deren Schichtdicke 2 bis 20 Mikrometer. Bei einer galvanisch abgeschiedenen Schicht 19 wurde eine Schichtdicke von 5 bis 10 Mikrometer verwendet.

Zur Herstellung der elektrisch leitenden Verbindung wird das mit der Schicht 19 versehene Kontaktteil 14 auf die Kontaktstelle 12 des Substrats gelegt und mittels eines Diffusionslötverfahrens bzw. eines Diffusionsschweißverfahrens gefügt. Dabei entsteht eine stotfschlüssige Verbindung zwischen der Kontaktstelle 12 und der Schicht 19 des Kontaktteils 14.

Das Diffusionslötverfahren wird zweckmäßigerweise unter Schutzgas durchgeführt, wobei als Schutzgasatmosphäre Argon, Helium oder Stickstoff verwendet wird. Die Fügetemperatur liegt bei nur 750 bis 950 °C je nach Pd/Ni-Legierung. Zusätzlich wird die Fügestelle mit einer Anpreßkraft belegt, die 1 bis 50 Newton/mm², vorzugsweise 1 bis 20 Newton/mm² beträgt.

Die Fügetemperatur wird beispielsweise durch eine elektrische Widerstandserwärmung erzeugt, wobei eine Elektrode auf das Kontaktteil und eine Elektrode auf die Kontaktstelle aufgesetzt werden. Es ist außerdem denkbar, die Erwärmung auf Fügetemperatur mit einem HF-Heizstempel oder mittels eines Laserstrahls zu erzeugen. In allen Fällen ist jedoch entweder während der gesamten Erwärmungsphase oder mit Erreichen der Fügetemperatur ein Anpreßdruck zwischen Kontaktstelle 12 und Schicht 19 notwendig.

Eine mögliche Anwendung der erfindungsgemäßen, elektrisch leitenden Verbindung geht aus Figur 2 hervor. Hier ist ein anschlußseitiges Ende eines planaren Sensorelements 20 gezeigt, das in ein nicht dargestelltes Gehäuse eingesetzt ist und als Lambda-Sonde, beispielsweise zur Bestimmung des Sauerstoffgehaltes in Abgasen von Verbrennungsmotoren, Verwendung findet. Das Sensorelement 20 hat nicht dargestellte Elektroden und einen im Sensorelement integrierten elektrischen Widerstandsheizer. Die Elektroden und der Widerstandsheizer sind mittels jeweils in das planare Sensorelement 20 eingebetteten Leiterbahnen an das in Figur 2 gezeigte anschlußseitige Ende des Sensorelements 20 geführt. Dort sind die Leiterbahnen jeweils an die Oberfläche des Sensorelements 2 gelegt und sind dort als Kontaktstellen 22 ausgebildet. Im vorliegenden Ausführungsbeispiel sind auf jeder Großfläche des Sensorelements 20 jeweils zwei Kontaktstellen 22 angeordnet, wobei sich auf der einen Seite die Kontaktstellen für den Widerstandsheizer und auf der anderen Seite die Kontaktstellen für die Elektroden befinden. Die vier Kontaktstellen 22 sind jeweils mit einem Kontaktteil 24 kontaktiert. Die Kontaktteile 24 sind gemäß Figur 1 ausgeführt und werden gemäß dem bereits beschriebenen Verfahren mit den Kontaktstellen 22 verbunden. Die Kontaktstellen 22 bestehen hierbei ebenfalls aus einem Platin-Cermet-Material mit einem Platin-Gehalt von ≥ 95%. An dem den Kontaktstellen 22 gegenüberliegenden Ende sind die Kontaktteile 24 mit elektrischen Anschlußleitern 26 verbunden.

Die erfindungsgemäße elektrisch leitende Verbindung eignet sich ebenfalls für andere thermisch stabile Kontaktierungen, die zusätzlich eine hohe mechanische Festigkeit aufweisen müssen.

## Patentansprüche

1. Elektrisch leitende Verbindung zum Kontaktieren einer Kontaktstelle mit einem Kontaktteil, dadurch gekennzeichnet, daß zwischen Kontaktstelle (12, 22) und Kontaktteil (14, 24) eine diffusionsaktive Schicht (19) aus einer Palladium-Nickel-Legierung vorgesehen ist.

2. Elektrisch leitende Verbindung nach Anspruch 1, dadurch gekennzeichnet, daß die Schicht (19) am Kontaktteil (22, 24) ausgebildet ist.

3. Elektrisch leitende Verbindung nach Anspruch 1, dadurch gekennzeichnet, daß die Palladium-Nickel-Legierung 20 bis 60 Masseprozent Palladium und den Rest jeweils Nickel, vorzugsweise 60 Masseprozent Palladium und 40 Masseprozent Nickel enthält.

4. Elektrisch leitende Verbindung nach einem der vorhergehenden Ansprüche, dadurch gekennzeichnet, daß die Schichtdicke der Schicht (19) 2 bis 20 Mikrometer, vorzugsweise 5 bis 10 Mikrometer beträgt.

5. Verfahren zur Herstellung einer elektrisch leitenden Verbindung zwischen einer Kontaktstelle und einem Kontaktteil, dadurch gekennzeichnet, daß auf das Kontaktteil zumindest im Bereich der Kontaktstelle eine diffusionsaktive Schicht (19) aufgebracht wird, daß das Kontaktteil (14, 24) auf die Kontaktstelle (12, 22) positioniert wird und daß anschließend unter Einwirkung eines Anpreßdrucks das Kontaktteil (14, 24) zumindest im Bereich der Kontaktstelle (12) auf eine Diffusionslöttemperatur bzw. Diffusionsschweißtemperatur erwärmt wird.

6. Verfahren nach Anspruch 5, dadurch gekennzeichnet, daß die Diffusionslöttemperatur je nach Pd/Ni-Legierung 750 bis 950° C beträgt.

7. Verfahren nach Anspruch 5, dadurch gekennzeichnet, daß der Anpreßdruck 1 bis 50 Newton/mm², vorzugsweise 1 bis 20 Newton/mm² beträgt.
